# EUROPEAN PATENT APPLICATION

(11) **EP 4 693 805 A1**
(43) Date of publication of application: **11.02.2026**
(21) Application number: 24935289.9
(22) Date of filing: 05.12.2024
(51) Int. Cl.: H02J 7/00, G01R 31/3835, B60R 16/023

(54) **BATTERY DEVICE, BATTERY MANAGEMENT SYSTEM, AND LOW POWER MODE CONTROL METHOD**

(30) Priority: 27.03.2024 KR 20240041794
(71) Applicant: LG Energy Solution, Ltd., Seoul 07335 (KR)
(72) Inventor: CHOI, Jang Hyeok, Daejeon 34122 (KR); PARK, Myeonghui, Daejeon 34122 (KR)
(74) Representative: Plasseraud IP
(86) International application number: PCT/KR2024/019846
(87) International publication number: WO 2025/206523

(57) **Abstract**

In a battery management system, when a loss of communication occurs in a battery monitoring circuit for monitoring a battery module, a bridge circuit that transfers a signal between a processor and the battery monitoring circuit generates an interrupt. A power circuit wakes up in response to the interrupt input to an enable pin and generates a power supply voltage. The processor operates based on the power supply voltage and disables the enable pin when an error flag is set in an event of the loss of communication in the battery monitoring circuit.

## Description

### [Technical Field]

### CROSS-REFERENCE TO RELATED APPLICATION

This application claims priority to and the benefit of Korean Patent Application No. 10-2024-0041794 filed in the Korean Intellectual Property Office on March 27, 2024, the entire contents of which are incorporated herein by reference.

The disclosure is directed to a battery apparatus, a battery management system, and a method of controlling a low-power mode.

### [Background Art]

An electric vehicle or a hybrid vehicle is a vehicle that obtains power by driving a motor mainly using a battery as a power supply. The electric vehicles are being actively researched because they are alternatives that can solve pollution and energy problems of internal combustion vehicles. Further, batteries are used in various external apparatuses other than the electric vehicles.

The battery may enter a low-power mode when an external apparatus does not require power from the battery, for example, when a vehicle is in park. If the battery is in the low-power mode, an unintended operation of a battery management system may cause the battery management system to fail to return to the low-power mode after waking up from the low-power mode.

### [Disclosure]

### [Technical Problem]

Some embodiments may provide a battery apparatus, a battery management system, and a method of controlling a low-power mode that can return to a low-power mode after waking up due to an unintended operation.

### [Technical Solution]

According to some embodiments, a battery management system configured to manage a battery module may be provided. The battery management system may include a battery monitoring circuit configured to monitor the battery module, a power circuit configured to wake up in response to an interrupt input to a first enable pin and generate a power supply voltage, a processor configured to operate based on the power supply voltage and disable the first enable pin in response to an error flag being set when a loss of communication occurs in the battery monitoring circuit, and a bridge circuit configured to transfer a signal between the processor and the battery monitoring circuit and generate the interrupt when the loss of communication occurs in the battery monitoring circuit.

According to some embodiments, a battery apparatus may include a battery module and a battery management system. The battery management system may include a battery monitoring circuit configured to monitor the battery module, a power circuit including a first enable pin, a processor, and a bridge circuit configured to transfer a signal between the processor and the battery monitoring circuit. The bridge circuit may be further configured to generate an interrupt when a loss of communication occurs in the battery monitoring circuit being in a low-power mode. The power circuit may be further configured to wake up in response to the interrupt input to the first enable pin and generate a power supply voltage. The processor may be further configured to wake up based on the power supply voltage, recognize the loss of communication, set an error flag indicating the loss of communication, and request the battery management system to enter a low-power mode.

According to some embodiments, a method of controlling a low-power mode of a battery management system configured to manage a battery module may be provided. The method may include generating an interrupt in response to a loss of communication that occurs when the battery management system is in a low-power mode, generating a power supply voltage in response to the interrupt, setting an error flag indicating the loss of communication, and requesting the battery management system to enter the low-power mode.

### [Description of the Drawings]

FIG. 1 is a block diagram illustrating an example of a battery apparatus according to some embodiments.
FIG. 2 is a flowchart illustrating an example of a low-power mode control method of a battery management system according to some embodiments.
FIG. 3 is a block diagram illustrating an example of a battery apparatus according to some embodiments.
FIG. 4 is a block diagram illustrating an example of a battery apparatus according to some embodiments.
FIG. 5 is a flowchart illustrating an example of a low-power mode control method of a battery management system according to some embodiments.
FIG. 6 is a block diagram illustrating an example of a battery apparatus according to some embodiments.

### [Mode for Invention]

In the following detailed description, only certain embodiments of the present invention have been shown and described, simply by way of illustration. As those skilled in the art would realize, the described embodiments may be modified in various different ways, all without departing from the spirit or scope of the present invention. Accordingly, the drawings and description are to be regarded as illustrative in nature and not restrictive. Like reference numerals designate like elements throughout the specification.

When it is described that an element is "connected" to another element, it should be understood that the element may be directly connected to the other element or connected to the other element through a third element. On the other hand, when it is described that an element is "directly connected" to another element, it should be understood that the element is connected to the other element through no third element.

As used herein, a singular form may be intended to include a plural form as well, unless the explicit expression such as "one" or "single" is used.

In flowcharts described with reference to the drawings, the order of operations or steps may be changed, several operations or steps may be merged, a certain operation or step may be divided, and a specific operation or step may not be performed.

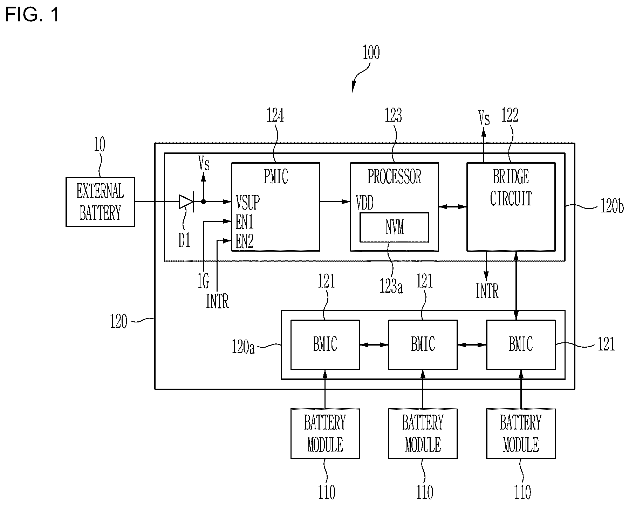

FIG. 1 is a block diagram illustrating an example of a battery apparatus according to some embodiments.

Referring to FIG. 1, a battery apparatus 100 may include a battery module 110 and a battery management system (BMS) 120. The battery apparatus 100 may be connected to an external apparatus. The external apparatus may be, for example, a mobility device, an electronic device, or an energy storage system (ESS). The mobility device may be, for example, a vehicle such as an electric vehicle, a hybrid vehicle, or a smart mobility. Hereinafter, for convenience of description, the external apparatus will be described as a vehicle.

In some embodiments, the battery apparatus 100 may include a plurality of battery modules 110. The plurality of battery modules 110 may be connected in series or in parallel. The battery modules 110 may include a plurality of battery cells. The plurality of battery cells may be connected, for example, in series.

The battery management system 120 may be connected to the battery module 110 to monitor and manage the battery module 110. The battery management system 120 may include a battery monitoring circuit 121, a bridge circuit 122, a processor 123, and a power circuit 124.

The battery monitoring circuit 121 may be connected to the battery module 110 to monitor states (e.g., cell voltages) of the battery cells included in the battery module 110. In some embodiments, the battery monitoring circuit 121 may include a plurality of battery monitoring circuits 121 corresponding to the plurality of battery modules 110, respectively. In some embodiments, one battery monitoring circuit 121 may correspond to two or more battery modules 110, or two or more battery monitoring circuit 121 may correspond to one battery module 110. For convenience, three battery modules 110 and three battery monitoring circuits 121 are shown in FIG. 1. In some embodiments, the battery monitoring circuit 121 may be provided as an integrated circuit (IC), and the battery monitoring circuit 121 provided as the IC is referred to as a battery monitoring IC (BMIC).

In some embodiments, the plurality of battery monitoring circuits 121 may be connected in series to communicate with each other. In some embodiments, the plurality of battery monitoring circuits 121 may be connected by a serial peripheral interface (SPI) bus to provide bi-directional communication between two battery monitoring circuits 121. In some embodiments, the SPI bus may be an isolated SPI (ISO-SPI) bus.

The bridge circuit 122 may translate a signal coming from the processor 123 and pass it to the battery monitoring circuit 121, or may translate a signal coming from the battery monitoring circuit 121 and pass it to the processor 123. In some embodiments, the bridge circuit 122 may be connected to the battery monitoring circuit 121, for example, a first battery monitoring circuit 121 among the plurality of battery monitoring circuits 121 via an SPI bus. In some embodiments, the SPI bus may be an isolated SPI (ISO-SPI) bus. In some embodiments, the bridge circuit 122 may be provided as an IC. The bridge circuit 122 provided as an IC is referred to as a bridge IC. When a loss of communication (LOC) occurs in the battery monitoring circuit 121 while the battery management system 120 is in sleep mode, the bridge circuit 122 may recognize the LOC and generate an interrupt INTR (e.g., a high-level interrupt (INTR)).

The processor 123 may control an overall operation of the battery management system 120. The processor 123 may be connected to the bridge circuit 122, and may transfer a signal of controlling the battery monitoring circuit 121 to the bridge circuit 122 or receive monitoring information provided by the battery monitoring circuit 121 through the bridge circuit 122 to manage the state of the battery module 110 or the states of the battery cells of the battery module 110. The processor 123 may be equipped with a non-volatile memory (NMV) 123a. In some embodiments, the non-volatile memory 123a may be embedded in the processor 123. In some embodiments, the non-volatile memory 123a may be mounted outside the processor 123 and connected to the processor 123 via a bus. In some embodiments, the processor 123 and the bridge circuit 122 may be connected via an SPI bus. In some embodiments, the processor 123 may be processing circuitry, for example, a microcontroller unit (MCU).

The power circuit 124 may supply a power supply voltage (e.g., 5 V) VDD to the processor 123. The power circuit 124 may convert a voltage supplied from an external battery 10, for example, an auxiliary battery 10 of the external apparatus, to the power supply voltage VDD. The power circuit 124 may enter a low-power mode as the battery management system 120 enters a sleep mode. While in the low-power mode, the power circuit 124 may wake up in response to the interrupt INTR from the bridge circuit 122. The power circuit 124 may also wake up in response to a signal (e.g., an ignition signal for a vehicle) IG that activates the external apparatus. In some embodiments, the processor 123 and the power circuit 124 may be connected via an SPI bus.

In some embodiments, the power circuit 124 may include a power management IC (PMIC). The PMIC 124 may include a power supply pin VSUP that receives the power supply voltage from the auxiliary battery 10, and enable pins EN1 and EN2. In some embodiments, the voltage from the auxiliary battery 10 may be supplied to the power pin VSUP via a diode D1. The ignition signal IG may be input to the enable pin EN1, and the interrupt INTR may be input to the enable pin EN2. Thus, the PMIC 124 in the low-power mode may wake up in response to the ignition signal IG input to the enable pin EN1 (e.g., the ignition signal IG with the high level) or the interrupt INTR input to the enable pin EN2 (e.g., the interrupt INTR with the high level), and convert the voltage input to the power pin VSUP to the power supply voltage VDD of the processor 123. As the processor 123 operates using the power supply voltage VDD as a power source, the battery management system 120 may wake up from the sleep mode.

In some embodiments, the voltage supplied from the auxiliary battery 10 (e.g., the voltage supplied from the auxiliary battery 10 through the diode D1) may be provided as a power supply voltage Vs for the bridge circuit 122.

In some embodiments, a unit 120a including the battery monitoring circuit 121 may be referred to as a cell monitoring unit (CMU) or a high voltage (HV) unit, and a unit 120b including the bridge circuit 122, the processor 123, and the power circuit 124 may be referred to as a battery monitoring unit (BMU) or a low voltage (LV) unit.

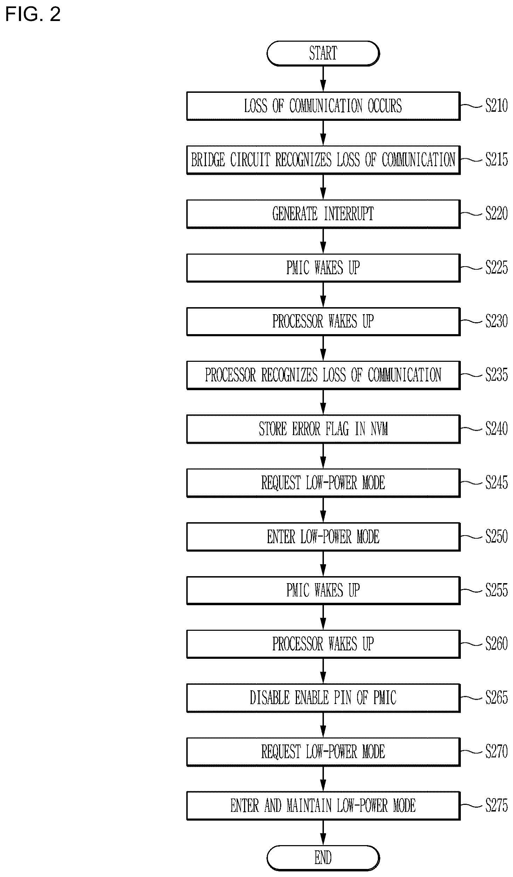

FIG. 2 is a flowchart illustrating an example of a low-power mode control method of a battery management system according to some embodiments.

Referring to FIGS. 1 and 2, if a loss of communication occurs in a battery monitoring circuit 121 (S210), a bridge circuit 122 may recognize the loss of communication (S215). The bridge circuit 122 may generate an interrupt INTR in response to the loss of communication (S220). A power circuit 124, for example, a PMIC 124, may wake up in response to the interrupt INTR, and convert a voltage from an auxiliary battery 10 to a power supply voltage VDD (S225).

A processor 123 may wake up when the power supply voltage VDD is input from the PMIC 124, and operate using the power supply voltage VDD as a power source (S230). Accordingly, the processor 123 may recognize the loss of communication in the battery monitoring circuit 121 and refer to a non-volatile memory 123a equipped to the processor 123 (S235). If an error flag indicating the loss of communication in the battery monitoring circuit 121 has not been set in the non-volatile memory 123a, the processor 123 may set (i.e., store) the error flag in the non-volatile memory 123a (S240). Since the battery management system 120 has woken up due to the loss of communication, the processor 123 may request that the battery management system 120 enter a sleep mode (S245). Accordingly, the PMIC 124 may enter the low-power mode, and the processor 123 may also enter the low-power mode since no power supply voltage VDD is supplied from the PMIC 124 (S250).

On the other hand, if the loss of communication in the battery monitoring circuit 121 continues after the battery management system 120 enters the sleep mode (i.e., the low-power mode), the bridge circuit 122 may generate an interrupt INTR. Accordingly, the PMIC 124, which has entered the low-power mode again, may wake up in response to the interrupt INTR (S255), and the processor 123 may also wake up as the power supply voltage VDD is supplied from the PMIC 124 (S260).

The processor 123 may refer to the non-volatile memory 123a after waking up, and disable an enable pin EN2 of the PMIC 124 if the error flag is set in the non-volatile memory 123a (S265). That is, the processor 123 may disable receiving the interrupt INTR from the PMIC 124 if the error flag is set (S265). In some embodiments, the processor 123 may disable the enable pin EN2 of the PMIC 124 using an SPI communication. Since the battery management system 120 has woken up due to the loss of communication, the processor 123 may request that the battery management system 120 enter the sleep mode (S270). Accordingly, the PMIC 124 may enter the low-power mode, and the processor 123 may also enter a low-power mode since there is no power supply voltage VDD being supplied from the PMIC 124 (S275). On the other hand, even if the loss of communication in the battery monitoring circuit 121 continues after the battery management system 120 enters the sleep mode, the PMIC 124 may remain in the low-power mode without waking up by the interrupt INTR because the enable pin EN2 of the PMIC 124 has been disabled (S275).

As described above, if the error flag is not set in the non-volatile memory 123a, an unintentional failure such as the loss of communication may prevent the battery management system from maintaining the low-power mode. However, in some embodiments, if the error flag is set in the non-volatile memory 123a, since receiving the interrupts INTR from the power circuit 124 is disabled, the battery management system may remain in the low-power mode.

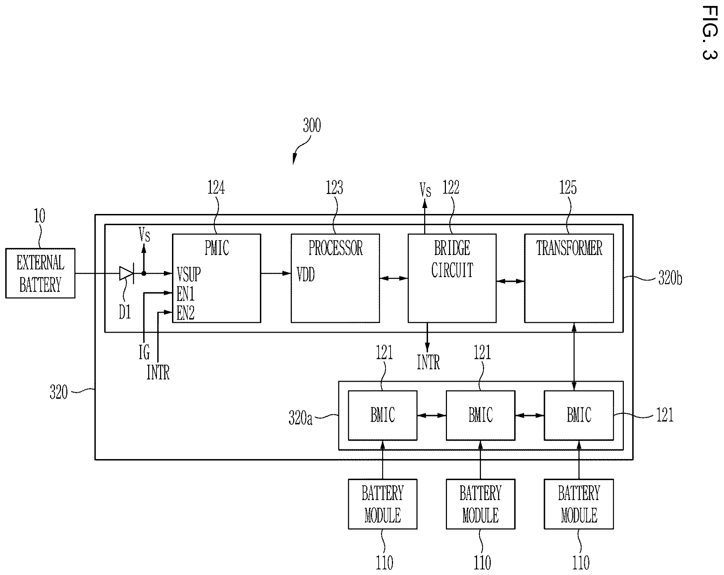

FIG. 3 is a block diagram illustrating an example of a battery apparatus according to some embodiments.

Referring to FIG. 3, a battery management system 320 of a battery apparatus 300 may further include a transformer 125 that connects an HV unit (i.e., a first battery monitoring circuit 121) 320b and an LV unit (i.e., a bridge circuit 122) 320a, compared to a battery management system 120 described with reference to FIG. 1. Therefore, the bridge circuit 122 may receive monitoring information from the battery monitoring circuit 121 via the transformer 125.

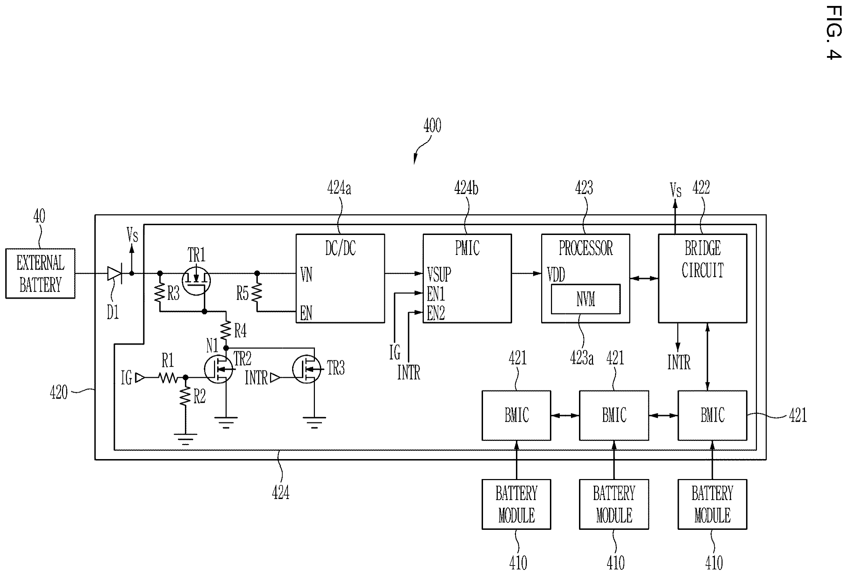

FIG. 4 is a block diagram illustrating an example of a battery apparatus according to some embodiments.

Referring to FIG. 4, a battery apparatus 400 may include a battery module 410 and a battery management system 420. The battery apparatus 400 may be connected to an external apparatus. In some embodiments, the battery apparatus 400 may include a plurality of battery modules 410.

The battery management system 420 may be connected to the battery module 410 to monitor and manage the battery module 410. The battery management system 420 may include a battery monitoring circuit 421, a bridge circuit 422, a processor 423, and a power circuit 424.

The battery module 410, the battery monitoring circuit 421, the bridge circuit 422, and the processor 423 perform the same or similar operations as the battery module 110, the battery monitoring circuit 121, the bridge circuit 122, and the processor 123 described with reference to FIG. 1, and therefore will not be described in detail.

The power circuit 424 may supply a power supply voltage VDD to the processor 423. The power circuit 424 may convert a voltage supplied from an external battery 40, for example, an auxiliary battery 40 of the external apparatus, to the power supply voltage VDD. The power circuit 424 may enter a low-power mode as the battery management system 420 enters a sleep mode.

In some embodiments, the power circuit 424 may include a direct current (DC)/DC converter 424a and a PMIC 424b. The DC/DC converter 424a may receive the voltage from the auxiliary battery 40 and convert the voltage from the auxiliary battery 40 to a predetermined voltage, for example, 12 V. The DC/DC converter 424a may be, for example, a buck/boost converter. The PMIC 424b may receive the predetermined voltage from the DC/DC converter 424a and convert the predetermined voltage to a power supply voltage (e.g., 5V) VDD.

The power circuit 424 in the low-power mode may wake up in response to an interrupt INTR from the bridge circuit 422. The power circuit 424 may also wake up in response to a signal that activates an external apparatus (e.g., an ignition signal for a vehicle) IG. In some embodiments, the processor 423 and the power circuit 424, for example, the PMIC 424b, may be connected via an SPI bus.

In some embodiments, the DC/DC converter 424a may include a power pin VN that receives the voltage from the auxiliary battery 40 and an enable pin EN that enables the DC/DC converter 424a. In some embodiments, the power circuit 424 may further include a transistor TR2 that turns on in response to the ignition signal IG, a transistor TR3 that turns on in response to the interrupt INTR, and a transistor TR1 that transfers the voltage from the auxiliary battery 40 to the power pin VN and the enable pin EN of the DC/DC converter 424a in response to turn-on of the transistor TR2 or TR3.

For example, the transistors TR1, TR2, and TR3 may be n-channel field effect transistors (FETs). In this case, drains of the transistors TR2 and TR3 may be connected to a node N1, and sources of the transistors TR2 and TR3 may be connected to a ground terminal. The resistors R1 and R2 may be connected in series between an input terminal to which the starting signal IG is input and the ground terminal, and a contact of the resistors R1 and R2 may be connected to a gate of the transistor TR2. In other words, a voltage of the ignition signal IG may be divided by the resistors R1 and R2 and input to the gate of the transistor TR2. The interrupt INTR may be input to a gate of transistor TR3. The resistors R3 and R4 may be connected in series between a drain of the transistor TR1 and the node N1, and a contact of the resistors R3 and R4 may be connected to a gate of the transistor TR1. The drain of the transistor TR1 may be supplied with the voltage of the auxiliary battery 40, and a source of the transistor TR1 may be connected to the power pin VN and the enable pin EN. The source of the transistor TR1 may be connected to the enable pin EN via a resistor R5. Further, the voltage from the auxiliary battery 40 may be supplied to the drain of the transistor TR1 via a diode D1.

Accordingly, when the ignition signal IG is input, the transistor TR1 may be turned on, and by the turn-on of the transistor TR1, the voltage of the auxiliary battery 40, which is divided by the resistors R3 and R4, may be applied to the gate of the transistor TR3, causing the transistor TR3 to be turned on. Similarly, when the interrupt INTR is input, the transistor TR1 may be turned on, and by the turn-on of the transistor TR1, the voltage of the auxiliary battery 40, which is divided by the resistors R3 and R4, may be applied to the gate of the transistor TR3, causing the transistor TR3 to be turned on. By turning on the transistor TR3, the voltage of the auxiliary battery 40 may be input to the enable pin EN, causing the DC/DC converter 424a to wake up and convert the voltage of the auxiliary battery 40 supplied to the power pin VN to the predetermined voltage.

In some embodiments, the PMIC 424b may include a power pin VSUP that receives the predetermined voltage from the DC/DC converter 424a and enable pins EN1 and EN2. The ignition signal IG may be input to the enable pin EN1, and the interrupt INTR may be input to the enable pin EN2. Therefore, the PMIC 424 in the low-power mode may wake up in response to the ignition signal IG input to the enable pin EN1 or the interrupt INTR input to the enable pin EN2, and convert the voltage input to the power pin VSUP to the power supply voltage VDD of the processor 423. As the processor 423 operates using the power supply voltage VDD as a power source, the battery management system 420 may wake up from the sleep mode.

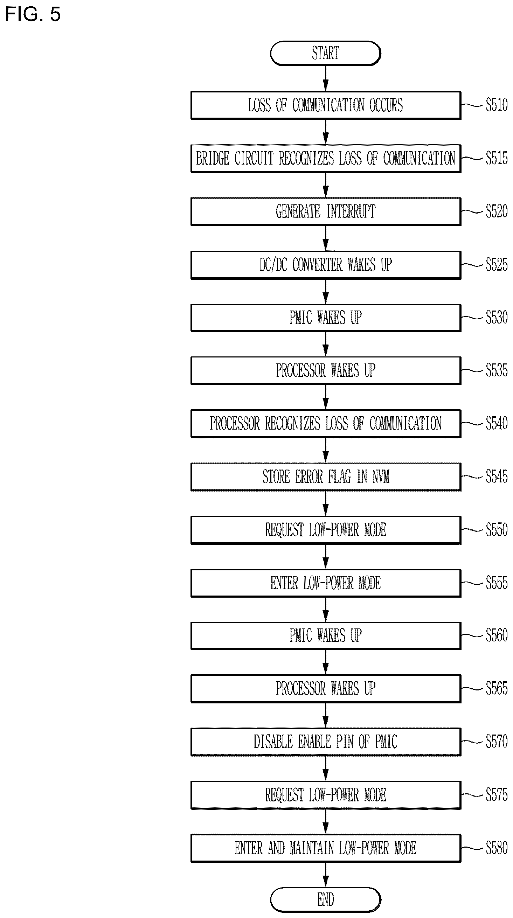

FIG. 5 is a flowchart illustrating an example of a low-power mode control method of a battery management system according to some embodiments.

Referring to FIGS. 4 and 5, if a loss of communication occurs in a battery monitoring circuit 421 (S510), a bridge circuit 422 may recognize the loss of communication (S515). The bridge circuit 422 may generate an interrupt INTR in response to the loss of communication (S520). A DC/DC converter 424a of a power circuit 424 may wake up in response to the interrupt INTR, and convert a voltage of an auxiliary battery 40 to a predetermined voltage (S525). A PMIC 424b may wake up in response to the interrupt INTR, and convert the predetermined voltage supplied from the DC/DC converter 424a to a power supply voltage VDD (S530).

A processor 423 may wake up when the power supply voltage VDD is input from the PMIC 424b, and operate using the power supply voltage VDD as a power source (S535). Accordingly, the processor 423 may recognize the loss of communication in the battery monitoring circuit 421, and refer to a non-volatile memory 423a equipped to the processor 423 (S540). If an error flag indicating the loss of communication in the battery monitoring circuit 421 has not been set in the non-volatile memory 423a, the processor 423 may set (i.e., store) the error flag in the non-volatile memory 423a (S545). Since the battery management system 420 has woken up due to the loss of communication, the processor 423 may request that the battery management system 420 enter a sleep mode (S550). Accordingly, the PMIC 424b may enter the low-power mode, and the processor 423 may also enter the low-power mode since there is no supply voltage VDD is supplied from the PMIC 424b (S555). In some embodiments, the DC/DC converter 424a may also enter the low-power mode (S555).

On the other hand, if the loss of communication in the battery monitoring circuit 421 continues after the battery management system 420 enters the sleep mode (i.e., the low-power mode), the bridge circuit 422 may generate an interrupt INTR. Accordingly, the PMIC 424b, which has entered the low-power mode again, may wake up in response to the interrupt INTR (S560), and the processor 423 may also wake up as the power supply voltage VDD is supplied from the PMIC 424b (S565). In some embodiments, the DC/DC converter 424a, which has entered the low-power mode, may also wake up in response to the interrupt INTR (S560).

The processor 423 may refer to the non-volatile memory 423a after waking up, and disable an enable pin EN2 of the PMIC 424b if the error flag is set in the non-volatile memory 423a (S570). That is, the processor 423 may disable receiving the interrupt INTR from the PMIC 424b if the error flag is set (S570). In some embodiments, the processor 423 may disable the enable pin EN2 of the PMIC 424b using an SPI communication. Since the battery management system 420 has woken up due to the loss of communication, the processor 423 may request that the battery management system 420 enters the sleep mode (S575). Accordingly, the PMIC 424b may enter the low-power mode, and the processor 423 may also enter the low-power mode since there is no power supply voltage VDD being supplied from the PMIC 424b (S580). On the other hand, even if the loss of communication in the battery monitoring circuit 421 continues after the battery management system 420 enters the sleep mode, the PMIC 424b may remain in the low-power mode without waking up by the interrupt INTR because the enable pin EN2 of the PMIC 424b has been disabled (S580).

As described above, if the error flag is not set in non-volatile memory 423a, an unintentional failure such as the loss of communication may prevent the battery management system from maintaining the low-power mode. However, in some embodiments, if the error flag is set in the non-volatile memory 423a, since receiving interrupt INTR from the power circuit 424 is disabled, the battery management system may remain in the low-power mode.

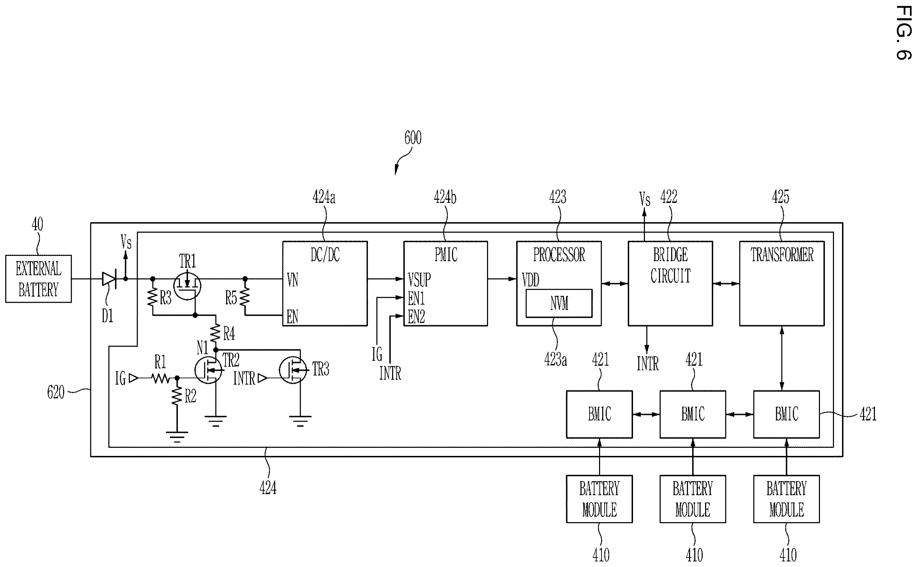

FIG. 6 is a block diagram illustrating an example of a battery apparatus according to some embodiments.

Referring to FIG. 6, a battery management system 620 of a battery apparatus 600 may further include a transformer 625 that connects an HV unit (i.e., a first battery monitoring circuit 621) and an LV unit (i.e., a bridge circuit 622), compared to a battery management system 420 described with reference to FIG. 4. Therefore, the bridge circuit 622 may receive monitoring information from the battery monitoring circuit 121 via the transformer 425.

While this invention has been described in connection with what is presently considered to be practical embodiments, it is to be understood that the invention is not limited to the disclosed embodiments. On the contrary, it is intended to cover various modifications and equivalent arrangements included within the spirit and scope of the appended claims.

## Claims

1. A battery management system configured to manage a battery module, the battery management system comprising:
a battery monitoring circuit configured to monitor the battery module;
a power circuit configured to wake up in response to an interrupt input to a first enable pin and generate a power supply voltage;
a processor configured to operate based on the power supply voltage, and disable the first enable pin in response to an error flag being set when a loss of communication occurs in the battery monitoring circuit; and
a bridge circuit configured to transfer a signal between the processor and the battery monitoring circuit, and generate the interrupt when the loss of communication occurs in the battery monitoring circuit.

2. The battery management system of claim 1, wherein the processor is further configured to set the error flag in response the error flag being not set, in the event of the loss of communication.

3. The battery management system of claim 1, wherein the processor comprises a non-volatile memory, and is further configured to store the error flag in the non-volatile memory.

4. The battery management system of claim 1, further comprising a non-volatile memory,
wherein the processor is further configured to store the error flag in the nonvolatile memory.

5. The battery management system of claim 1, wherein the processor is further configured to:
wake up in response to the power supply voltage and recognize the loss of communication; and
in response to the error flag being not set, set the error flag and then request the battery management system to enter a low-power mode, and
wherein the power circuit is further configured to enter the low-power mode in response to a request of entering the low-power mode.

6. The battery management system of claim 5, wherein when the power circuit wakes up in response to the interrupt, the processor is further configured to:
wake up in response to the power supply voltage and recognize the loss of communication;
disable the first enable pin in response to the error flag; and
request the battery management system to enter the low-power mode, and
wherein the power circuit is further configured to enter the low-power mode in response to a request of entering the low-power mode.

7. The battery management system of claim 1, wherein the power circuit comprises a power management integrated circuit configured to generate the power supply voltage based on a voltage from an external battery, and
wherein the power management integrated circuit comprises:
a power pin to which the voltage from the external battery is input;
the first enable pin; and
a second enable pin to which an ignition signal according to ignition of an external apparatus is input.

8. The battery management system of claim 1, wherein the power circuit comprises:
a DC/DC converter configured to convert a first voltage from an external battery to a second voltage; and
a power management integrated circuit configured to generate the power supply voltage based on the second voltage, and
wherein the power management integrated circuit comprises:
a first power pin to which the second voltage is input,
the first enable pin; and
a second enable pin to which an ignition signal according to ignition of an external apparatus is input.

9. The battery management system of claim 8, wherein the power circuit further comprises a first transistor configured to be turned on in response to the ignition signal or the interrupt to transfer the first voltage from the external battery, and
wherein the DC/DC converter comprises:
a second power pin to which the first voltage is input; and
an enable pin to which the first voltage is input.

10. The battery management system of claim 9, wherein the power circuit further comprises:
a second transistor configured to be turned on in response to the ignition signal; and
a third transistor configured to be turned on in response to the interrupt, and
wherein the first transistor is further configured to be turned on in response to turn-on of the second transistor or turn-on of the third transistor.

11. A battery apparatus comprising:
a battery module; and
a battery management system,
wherein the battery management system comprises:
a battery monitoring circuit configured to monitor the battery module;
a power circuit comprising a first enable pin;
a processor; and
a bridge circuit configured to transfer a signal between the processor and the battery monitoring circuit,
wherein the bridge circuit is further configured to generate an interrupt when a loss of communication occurs in the battery monitoring circuit being in a low-power mode,
wherein the power circuit is further configured to wake up in response to the interrupt input to the first enable pin and generate a power supply voltage, and
wherein the processor is further configured to wake up based on the power supply voltage, recognize the loss of communication, set an error flag indicating the loss of communication, and request the battery management system to enter a low-power mode.

12. The battery apparatus of claim 11, wherein the bridge circuit is further configured to generate the interrupt when the loss of communication continues in the battery monitoring circuit after the battery management system enters the low-power mode,
wherein the power circuit is further configured to wake up in response to the interrupt input to the first enable pin and generate the power supply voltage, and
wherein the processor is further configured to wake up based on the power supply voltage, recognize the loss of communication failure, disable the first enable pin in response to the error flag being set, and request the battery management system to enter the low-power mode.

13. The battery apparatus of claim 11, wherein the processor comprises a non-volatile memory, and is further configured to store the error flag in the non-volatile memory.

14. The battery apparatus of claim 11, wherein the battery management system further comprises a non-volatile memory,
wherein the processor is further configured to store the error flag in the non-volatile memory.

15. The battery apparatus of claim 11, wherein the power circuit comprises a power management integrated circuit configured to generate the power supply voltage based on a voltage from an external battery, and
wherein the power management integrated circuit comprises:
a power pin to which the voltage from the external battery is input;
the first enable pin; and
a second enable pin to which an ignition signal according to ignition of an external apparatus.

16. The battery apparatus of claim 11, wherein the power circuit comprises:
a DC/DC converter configured to convert a first voltage from an external battery to a second voltage; and
a power management integrated circuit configured to generate the power supply voltage based on the second voltage, and
wherein the power management integrated circuit comprises:
a first power pin to which the first voltage is input;
the first enable pin; and
a second enable pin to which an ignition signal according to ignition of an external apparatus.

17. A method of controlling a low-power mode of a battery management system configured to manage a battery module, the method comprising:
generating an interrupt in response to a loss of communication that occurs when the battery management system is in a low-power mode;
generating a power supply voltage in response to the interrupt;
setting an error flag indicating the loss of communication; and
requesting the battery management system to enter the low-power mode.

18. The method of claim 17, further comprising:
generating the interrupt in response to the loss of communication continuing in the battery monitoring circuit after the battery management system enters the low-power mode;
generating the power supply voltage in response to the interrupt;
disabling receiving the interrupt in response to the error flag being set; and
requesting the battery management system to enter the low-power mode.
